# EUROPEAN PATENT APPLICATION

(11) **EP 1 333 488 A2**
(43) Date of publication of application: **06.08.2003**
(21) Application number: 03250214.8
(22) Date of filing: 14.01.2003
(51) Int. Cl.: H01L 23/26, H01J 29/94

(54) **Electronic device having a getter used as a circuit element**

(30) Priority: 28.01.2002 US 59817
(71) Applicant: Hewlett-Packard Company, Palo Alto, CA 94304 (US)
(72) Inventor: Liebeskind, John, Corvallis, OR 97330 (US); McKinnell, James C., Salem, OR 97304 (US); Chen, Chien-Hua, Corvallis, OR 97330 (US)
(74) Representative: Jackson, Richard Eric

(57) **Abstract**

An electronic device (100,700) includes a non-evaporable getter material (104) having a surface exposed to a low pressure and one or more circuit elements. The non-evaporable getter material forms at least a portion of the one or more circuit elements (102, 550, 560, 570). The electronic device further includes one or more vacuum devices (140, 240, 340, 440, 640) electrically coupled to the one or more circuit element.

## Description

### BACKGROUND OF THE INVENTION

The ability to maintain a low pressure or vacuum for a prolonged period in a microelectronic package is increasingly being sought in such diverse areas as field emission displays (FEDs), micro-electro-mechanical systems (MEMS) and atomic resolution storage devices (ARS). For example, computers, displays, and personal digital assistants may all incorporate such devices. Both FEDs and ARS typically require two surfaces juxtaposed to one another across a narrow vacuum gap. Typically, electrons must transverse this gap either to excite a phosphor in the case of FEDs or to modify a media to create bits in the case of ARS.

One of the major problems with vacuum packaging of electronic devices is the continuous outgassing of hydrogen, water vapor, carbon monoxide, and other components found in ambient air, and from the internal components of the electronic device. To minimize the effects of outgassing one typically uses gas-absorbing materials commonly referred to as getter materials. Normally a separate cartridge, ribbon or pill incorporates the getter material that is inserted into the electronic vacuum package. Thus, in order to maintain the low pressure, over the lifetime of the electronic device, a sufficient amount of getter material must be contained within the cartridge or cartridges, before the cartridge or cartridges are sealed within the vacuum package. A path of sufficient cross sectional area to allow for the gaseous material outgassing, from various surfaces of the device, to impinge upon the surface of the getter material is necessary for efficient pumping action.

In conventional getter cartridges the getter material is deposited onto a metal substrate and then activated using electrical resistance, RF, or laser power to heat the getter material to a temperature at which the passivation layer on the surface diffuses into the bulk of the material. Non-evaporable getter material is activated in a temperature range of 250 °- 900 °C depending on the particular material used. At temperatures above 450° C most active semiconductor devices as well as polymeric materials will be damaged, deformed, or degraded.

In order to avoid these damaging effects the getter material typically is kept apart from the actual device, thus leading to increased complexity and difficulty in assembly as well as increased package size. Especially for small electronic devices with narrow vacuum gaps, the incorporation of a separate cartridge also results in a bulkier package, which is undesirable in many applications. Further, the utilization of a separate cartridge increases the cost of manufacturing because it is a separate part that requires accurate positioning, mounting, and securing to another component part to prevent it from coming loose and potentially damaging the device.

Providing an auxiliary compartment situated outside the main compartment is one alternative others have taken. The auxiliary compartment is connected to the main compartment such that the two compartments reach largely the same steady-state pressure. Although this approach provides an alternative to the potential damage caused by the high activation temperatures typically required for getter materials, it results in the undesired effect of producing either a thicker or a larger package.

Depositing the getter material on a surface other than the actual device such as a package surface is another alternative approach taken by others. A uniform vacuum can be produced by producing a uniform distribution of pores through the substrate of the device along with a uniform distribution of getter material deposited on the closing plate of the package. Although this approach provides an efficient means of obtaining a uniform vacuum within the vacuum package, it also will typically result in the undesired effect of producing a thicker package, because of the need to maintain a reasonable gap between the bottom surface of the substrate and the top surface of the getter material to allow for reasonable pumping action. in addition, yields typically decrease due to the additional processing steps necessary to produce the uniform distribution of pores. Even when the getter material is deposited on the surface of the device, the getter material takes up additional valuable space. Accordingly, there is a problem generating a small thin vacuum packaged electronic device. As the demands for smaller and lower cost electronic devices continues to grow, the demand to minimize both the die size and the package size will continue to increase as well.

### SUMMARY OF THE INVENTION

An electronic device includes a non-evaporable getter material having a surface exposed to a low pressure and one or more circuit elements. The non-evaporable getter material forms at least a portion of the one or more circuit elements. The electronic device further includes one or more vacuum devices electrically coupled to the one or more circuit element.

### BRIEF DESCRIPTION OF THE DRAWINGS

Fig. 1 is a block diagram of an electronic device according to an embodiment of this invention;
Fig. 2 is a cross-sectional view of an electronic device according to an embodiment of this invention;
Fig. 3 is a cross-sectional view of an electronic device according to an embodiment of this invention;
Fig. 4 is a cross-sectional view of an electronic device according to an embodiment of this invention;
Fig. 5 is a plan view of an electronic device according to an embodiment of this invention;
Fig. 6 is a cross-sectional view of an electronic device according to an embodiment of this invention;
Fig. 7 is a block diagram of an electronic device according to an embodiment of this invention;
Fig. 8 is a flow diagram of a method of manufacturing an electronic device according to an embodiment of this invention;
Fig. 9 is a flow diagram of a method of using an electronic device according to an embodiment of this invention.

### DETAILED DESCRIPTION

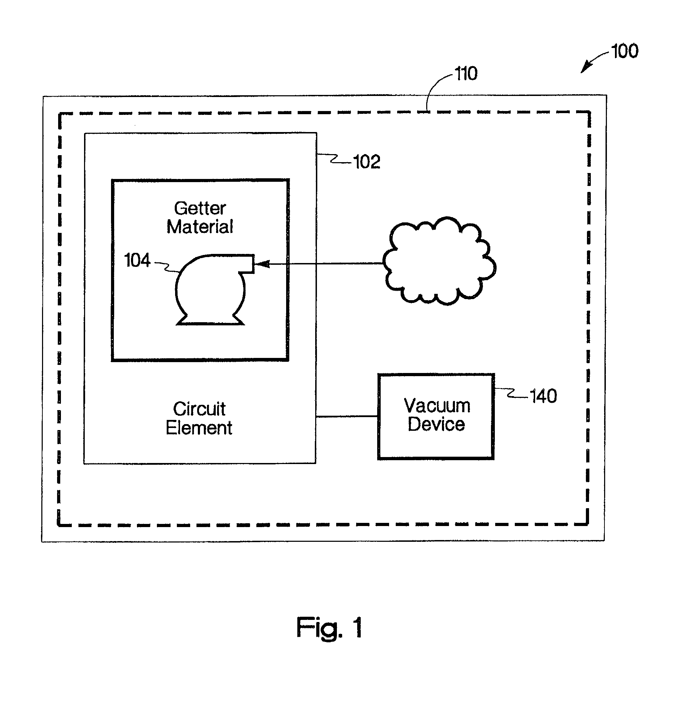

Referring to Fig. 1, an embodiment of electronic device 100 of the present invention in a simplified block diagram is shown. Non-evaporable getter material 104 is utilized as at least a portion of a circuit element 102. Getter material 104, thus, provides two functions; getter material 104 provides the gettering function to maintain a vacuum (i.e. the trapping of reactive gas particles at a low pressure) for vacuum device 140; in addition, getter material 104 also provides at least a portion of the electrical conduction function of circuit element 102. Unlike prior techniques, the present invention utilizes a portion of the surface area of substrate 110 that is already utilized for circuit elements for gettering as well, thereby providing for either a reduction in the size of the device substrate or an increase in the surface area of getter material 104 or some combination thereof. This is in marked contrast with prior techniques that use either a separate compartment or dedicated area on the device, package, or substrate, for getter material 104. The present invention may also provide for a more uniform vacuum over the surface of substrate 110 by utilizing getter material 104 in multiple circuit elements 102 such as, for example, capacitors, resistors, inductors, and even on electrical traces and shields. The uniformity of the reduced pressure over substrate 110 will, for example, depend on the particular application of the device as well as the layout requirements for the particular design utilized.

It should be noted that the drawings are not true to scale. Further, various parts of the active elements have not been drawn to scale. Certain dimensions have been exaggerated in relation to other dimensions in order to provide a clearer illustration and understanding of the present invention. In addition, although the embodiments illustrated herein are shown in two-dimensional views with various regions having depth and width, it should be understood that these regions are illustrations of only a portion of a device that is actually a three-dimensional structure. Accordingly, these regions will have three dimensions, including, length, width and depth, when fabricated on an actual device

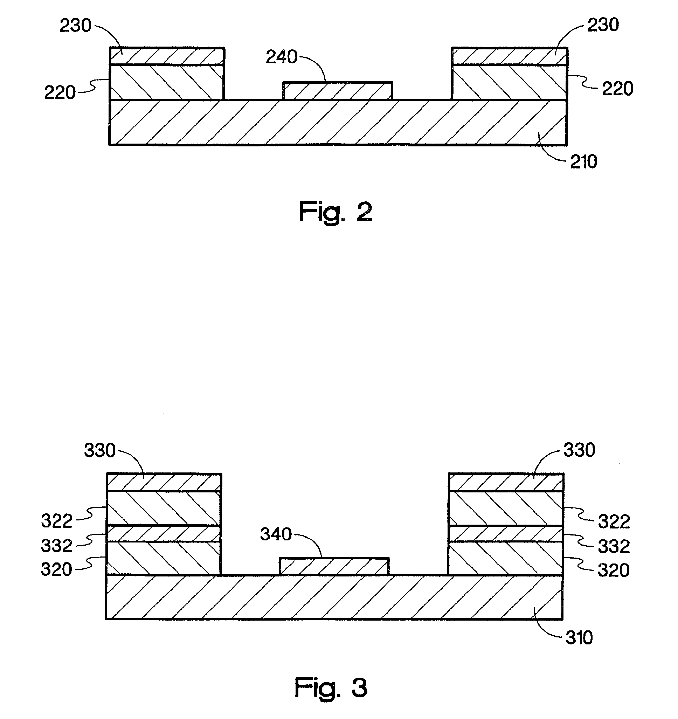

Referring to Fig. 2, an exemplary embodiment of the present invention is shown in a cross-sectional view. In this embodiment, vacuum device 240 is disposed over at least a portion of substrate 210. Preferably, vacuum device 240 is an electron emitter device commonly referred to as either a Spindt tip or a flat electron emitter. Dielectric or insulating layer 220 is disposed over substrate 210 and provides insulation between vacuum device 240 and electron lens 230. Application of the appropriate signal to the electron lens generates the necessary field gradient to focus electrons emitted from vacuum device 240 as is well known in the art. The present invention utilizes the conductive getter material to generate the necessary field gradient to focus electrons, in addition to providing the gettering of ambient gas particles to maintain the necessary reduced pressure for operation of the electronic device.

Substrate 210 is preferably manufactured using a silicon wafer having a thickness of about 300-700 microns. Next using standard semiconductor processing steps, well known in the art, vacuum device 240 as well as other logic devices required for the electronic device are formed on substrate 210. Although preferably, substrate 210 is silicon, other materials may also be utilized, such as, for example, various glasses, aluminum oxide, polyimide, silicon carbide, and gallium arsenide. Accordingly, the present invention is not intended to be limited to those devices fabricated in silicon semiconductor materials, but will include those devices fabricated in one or more of the available semiconductor materials and technologies well known in the art, such as thin-film-transistor (TFT) technology using polysilicon on glass substrates.

Electron lens 230, preferably, is fabricated using a non-evaporable getter material, however, depending upon the particular application of the electronic device electron lens 230 may also be composed of more than one conductive layer provided at least the top surface layer of electron lens 230 includes a non-evaporable getter material 104. Getter materials include titanium, zirconium, thorium, hafnium, vanadium, yttrium, niobium, tantalum, and molybdenum. Preferably, getter material 104 is a zirconium-based alloy such as Zr-Al, Zr-V, Zr-V-Ti, or Zr-V-Fe alloys, and more preferably Zr-V-Ti or Zr-V-Fe alloys because of the lower activation temperatures used for these materials. Getter material 104 in electron lens 230 is preferably applied using conventional sputtering, evaporation, or other vapor deposition techniques well known in the art. However, other techniques such as electrophoresis, manual, or mechanical application, including screen printing, sprays or suspensions of getter material 104 in a suspending medium, can also be utilized.

In general, getter material 104 has a uniform thickness between about 0.1 to about 10 microns, preferably between about 0.5 microns to about 5.0 microns, and more preferably between about 0.75 microns to about 1.25 microns. Getter material 104 forms a "pump" where the area and volume of getter material 104 determines the capacity of the pump. Normally there is a passivation layer on the surface of getter material 104 when exposed to ambient conditions. However, when heated to a sufficiently high temperature the passivation layer diffuses into the bulk of getter material 104 resulting in activation of getter material 104. This process of activation forms a clean surface upon which additional material may adsorb. Heating the electronic device in an oven, preferably, activates getter material 104; however, radio frequency power (RF), laser power, or heat generated by operation of the electronic device may also be used to activate getter material 104. The actual temperature used for activation depends on the particular composition of getter material 10⁴ and is preferably in the range of about 250°C to about 450°C.

Dielectric layer 220 provides electrical insulation between electron lens 230 and vacuum device 240 and other circuit elements or logic devices disposed on substrate 210. In general, dielectric layer 220 will have a uniform thickness range between about 0.1 microns to about 10 microns, preferably the range is about 2.5 microns to 7.5 microns and more preferably 5.0 microns. The particular composition, method of deposition, and deposition conditions of both dielectric layer 220 and getter material 104 are optimized to minimize residual stress in the electronic device. Preferably, dielectric layer 220 is silicon oxide (SiₓO_{y}), however, other dielectric materials such as silicon nitride, silicon carbide, aluminum oxide, boron nitride and dielectric materials as well as various combinations thereof can be utilized as is well known in the art. For example, dielectric layer 220 can include a first dielectric layer of silicon oxide (SiₓO_{y}) disposed over substrate 210 with a second dielectric layer of silicon nitride (SiₓN_{y}) disposed over the silicon oxide layer and a third dielectric layer of silicon carbide disposed over the silicon nitride layer.

An alternative embodiment of the present invention is shown in a cross-sectional view in Fig. 3. In this embodiment, getter material 104, as described in Fig. 1, is utilized as at least a portion of second lens element 330 of the electron lens system. Typically, second lens element 330 acts as a ground shield, although depending upon the particular application of the electronic device second lens element 330 may be used as, for example, a focusing lens. In addition, although Fig. 3 shows only a two lens structure comprising second lens element 330 and electron lens 332, other structures including multiple lens elements may also be utilized, depending on the particular spatial and temporal electron emission properties desired for a given application. Vacuum device 340 is disposed over at least a portion of substrate 310. Both vacuum device 340 and substrate 310 may have similar properties and characteristics as that described above and shown in Fig. 2. First insulating or dielectric layer 322 electrically isolates second lens element 330 from electron lens 332. Second insulating layer 320 electrically isolates electron lens 332 from vacuum device 340 similar to dielectric layer 120 shown in Fig. 2. Both insulating layer 320 and first dielectric layer 322 are preferably made of the same material and may be selected from any of the materials described for dielectric layer 120 described above and shown in Fig. 1. Electron lens 332 is fabricated using any of the well-known conductor technologies utilized in semiconductor processing. For example, electron lens 332 may be formed using aluminum, tungsten, tantalum, titanium nitride, copper, or gold to name a few. In general, electron lens 332 will have a uniform thickness in the range from about 0.075 to about 0.7 microns, and about 0.2 microns is preferable.

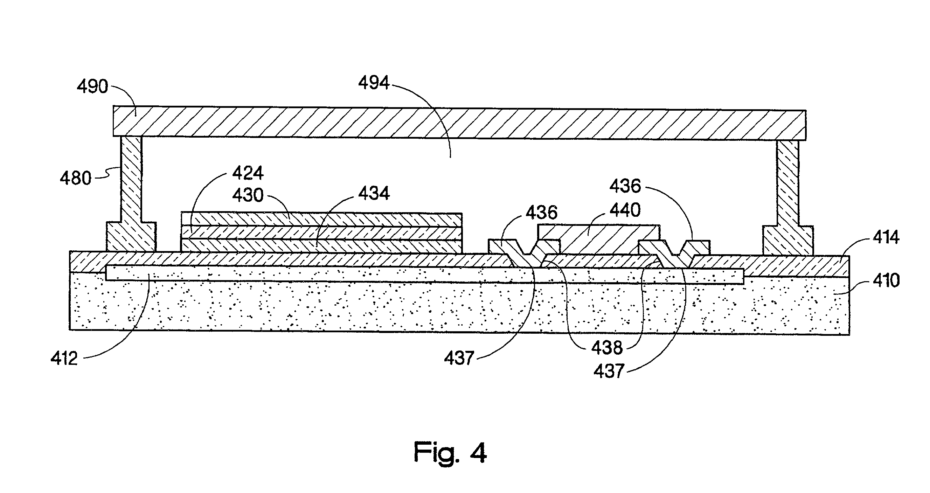

An alternate embodiment of the present invention is shown in a cross-sectional view in Fig. 4. In this embodiment, a capacitor formed by top electrode 430, bottom electrode 434, and capacitor dielectric layer 424 disposed over substrate 410 wherein top electrode 430 utilizes getter material. Although Fig. 4 depicts a planar construction utilizing a dielectric between two metal layers other capacitor structures, well known in the art may also be utilized. For example, a collector-base or emitter-base junction capacitor used in bipolar devices can be used where appropriate. Another example is a planar dielectric capacitor wherein getter material 104 forms the top or upper electrode and a doped semiconductor forms the bottom electrode with a dielectric layer interposed between the two conductive layers. In addition, in the later example, the metal interconnection to the doped semiconductor layer may also be formed using a getter material, provided the top metal surface is exposed to the vacuum environment.

With reference to Fig. 4, substrate 410 is preferably manufactured using a silicon wafer, although other substrates as described above may also be utilized. Transistors 412 are represented in Fig. 4 as only a single layer to simplify the drawing. Using semiconductor processing steps, well known in the art, transistors 412 as well as other logic devices required for the electronic device are formed in substrate 410 and are typically realized as a stack of thin film layers. The particular structure of transistors 412 is not relevant to the invention, however some type of solid state electronic device is preferably present, such as, metal oxide field effect transistors (MOSFET), bipolar junction transistors (BJT), or other active semiconductor elements.

Dielectric layer 414 is disposed over transistors 412 as well as other logic devices on substrate 410. Dielectric layer 414 provides electrical insulation between the capacitor and transistors 412 as well as between vacuum device 440 and transistors 412. Preferably, dielectric layer 414 is silicon oxide, however other dielectric materials as well as multiple layers may be used as described above.

Conductive layer 436 is disposed over dielectric layer 414 and electrically couples to electrical contact regions 437 of transistors 412 through via openings 438 formed in. the dielectric layer 414. Vacuum device 440 is disposed over a portion of dielectric layer 414. Preferably, vacuum device 440 is an electron emitter, however, devices such as a digital mirror device, digital micro mover as well as other devices utilized in field emission displays, atomic resolution storage systems and micro-electro-mechanical systems (MEMS) and micro-optical-electro-mechanical systems (MOEMS) that are incorporated within a vacuum package, maintained at a low pressure. Conductive layer 436 routes signals from transistors 412 as well as other logic devices to vacuum device 440 and may also be formed utilizing a getter material, especially those areas that have a top surface exposed to the low pressure environment. In addition, it is preferable where conductive layer 436 is composed of more than one conductive layer that at least the top surface layer includes a getter material.

As shown in Fig. 4 vacuum seal 480 is disposed on substrate 410 and cover 490 is affixed to vacuum seal 480 such that interspace region 494 is maintained at a pressure of less than 10⁻³ torr. Preferably, interspace region 494 is maintained at a pressure of less than 10⁻⁵ torr. However, some devices that fall within the scope of the present invention, for example, lasers or plasma displays, may utilize a low pressure of inert high purity gases at pressures less than about 50 torr. Vacuum seal 480 can be made by a variety of techniques including thermal compression, glass frit bonding, brazing, anodic bonding, as well as other techniques.

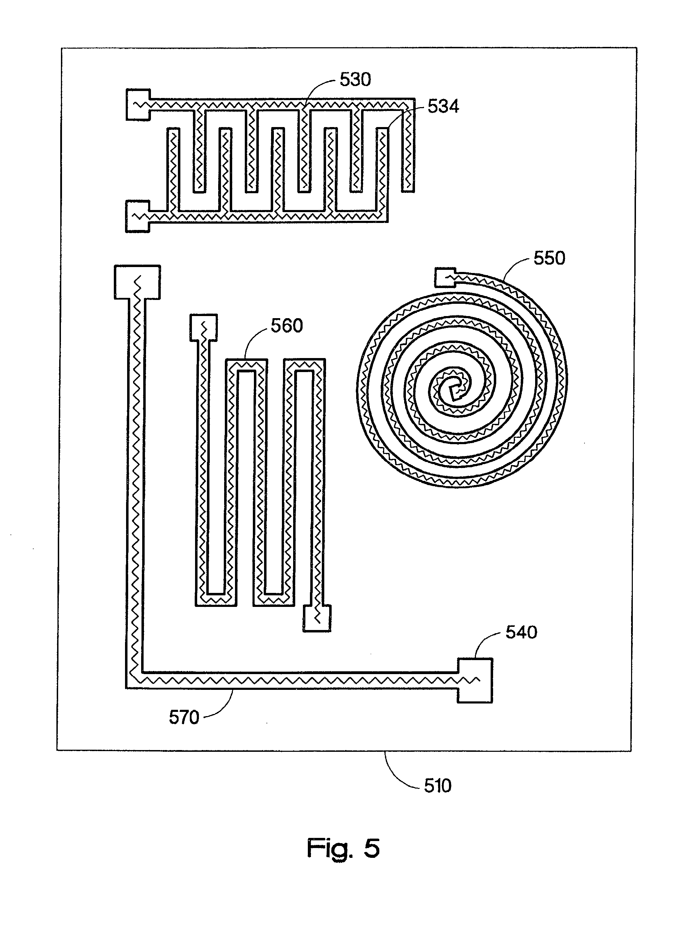

Referring to Fig. 5 an alternate embodiment of the present invention is shown in plan view. In this embodiment, getter material is, preferably, incorporated into a number of different passive circuit elements that would typically be found on electronic devices, however it may also be incorporated into active circuit elements such as Schottky contacts and metal contacts to transistors.

Disposed over substrate 510 are interdigitated capacitor electrodes 530 and 534, electrical trace 570, resistor 560, and inductor 550 each of which is fabricated using a non-evaporable getter material. However, depending upon the particular application of the electronic device each circuit element 550, 560, and 570 may also be composed of more than one conductive layer provided that at least the top surface layer of each circuit element includes a non-evaporable getter material. For example if electrical trace 570 and portion of trace end 540 represents a power trace that carries a higher current, then depending upon the particular application, it may be advantageous to utilize a getter material trace on top of a metal layer such as an aluminum or gold trace that minimizes the power dissipation within the combined metal trace. In addition the composition, thickness, and width may be chosen to also minimize the residual stress in the circuit element. The thickness or width or both, of the electrical trace 570 and portion of trace end 540 to may be increased to reduce power dissipation when appropriate.

Although Fig. 5 shows resistor 560 as a serpentine resistor other resistor structures well known in the art may also be utilized such as resistors formed via getter material acting as a contact to doped semiconductor in substrate 510. The present invention essentially may utilize any circuit element that contains a metallization layer that is exposed to the low pressure environment as a portion of a getter pump. This would also include active elements such as Schottky contacts, and gate metal contacts as just two examples.

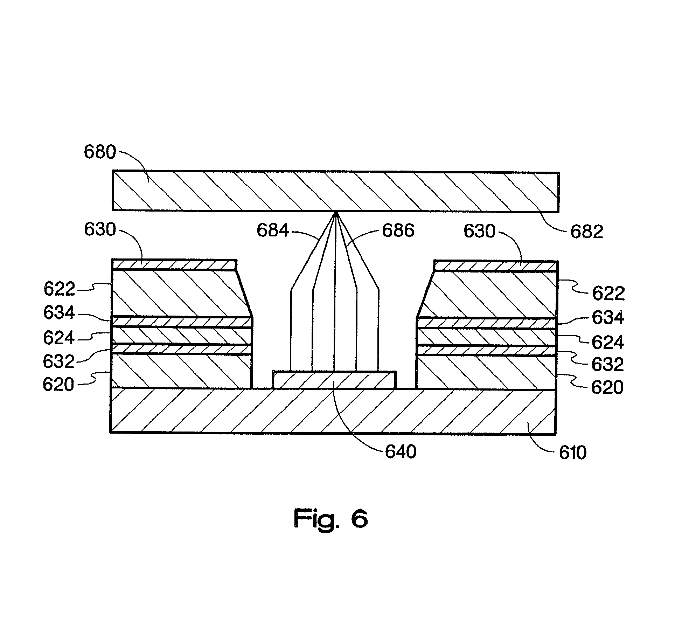

Fig. 6 is an exemplary embodiment of an electronic device having integrated vacuum device 640 that includes anode surface 682 such as a display screen or a mass storage device that is affected by electrons 684 when they are preferably formed into a focused beam 686. Anode surface 682 is held at a predetermined distance from second electron lens element 630. In this embodiment integrated vacuum device 640 is shown in a simplified block form and may be any of the emitter structures well known in the art such as a Spindt tip or flat emitter structure.

In this embodiment, getter material 104 is utilized as second lens element 630 of the electron lens system, wherein second lens element 630 acts as a ground shield. Vacuum device 640 is disposed over at least a portion of substrate 610. First insulating or dielectric layer 622 electrically isolates second lens element 630 from third lens element 634. Second insulating layer 620 electrically isolates electron lens 632 from vacuum device 640 and third insulating layer 624 electrically isolates third lens element 634 from electron lens 632. Both the lens elements and dielectrics are all fabricated using materials and processes well known in the art.

As a display screen, preferably an array of pixels (not shown) are formed on anode surface 682, which further are preferably arranged in a red, blue, green order, however, the array of pixels may also be a monochromatic color. An array of emitters (not shown) are formed on substrate 610 where each element of the emitter array has one or more integrated vacuum device acting as an electron emitter. Application of the appropriate signals to an electron lens structure including electron lens 632, third lens element 634, and second lens element 630 generates the necessary field gradient to focus electrons 684 emitted from vacuum device 640 and generate focused beam 686 on anode surface 682.

As a mass storage device, anode surface 682 preferably includes a phase-change material or storage medium that is affected by the energy of focused beam 686. The phase-change material preferably is able to change from a crystalline to an amorphous state (not shown) by using a high power level of focused beam 686 and rapidly decreasing the power level of focused beam 686. The phase-change material is able to change from an amorphous state to a crystalline state (not shown) by using a high power level of focused beam 686 and slowly decreasing the power level so that the media surface has time to anneal to the crystalline state. This change in phase is utilized to form a storage area on anode surface 682 that may be in one of a plurality of states depending on the power level of focused beam 686 used. These different states represent information stored in that storage area.

An exemplary material for the phase change media is germanium telluride (GeTe) and ternary alloys based on GeTe. The mass storage device also contains electronic circuitry (not shown) to move anode surface 682 in a first and preferably second direction relative to focused beam 686 to allow a single integrated vacuum device 640 to read and write multiple locations on anode surface 682. To read the data stored on anode or media surface 682, a lower-energy focused beam 686 strikes media surface 682 that causes electrons to flow through the media substrate 680 and a reader circuit (not shown) detects them. The amount of current detected is dependent on the state, amorphous or crystalline, of the media surface struck by focused beam 686.

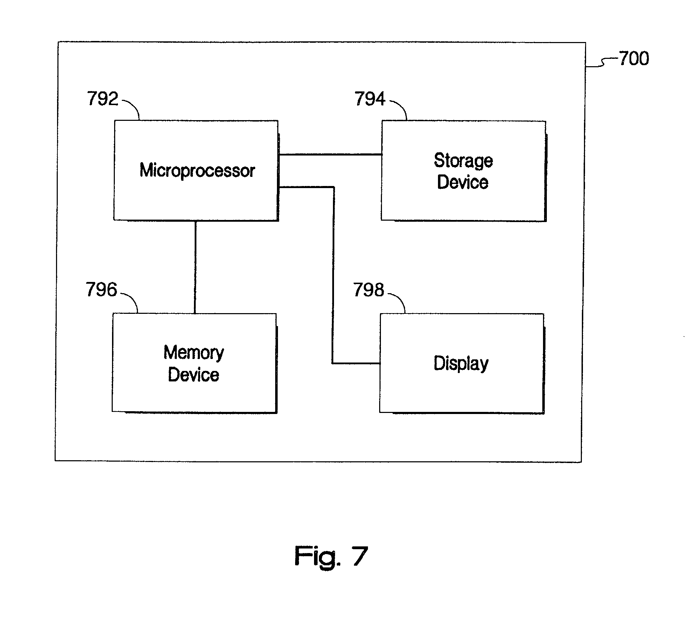

Referring to Fig. 7, an exemplary embodiment of electronic device 700 of the present invention in a simplified block diagram is shown. In this embodiment electronic device 700 may be a computer system, video game, Internet appliance, terminal, MP3 player, or personal data assistant to name just a few. Electronic device 700 includes microprocessor 792, such as an Intel Xeon or Pentium Processor™ or compatible processor although other processors exist and are well known in the art. Microprocessor 792 is connected to memory device 796 that includes computer readable memory that is capable of holding computer executable commands used by microprocessor 792 to control data or input/output functions or both. Memory device 796 can also store data that is manipulated by microprocessor 792. Microprocessor is also connected to either storage device 794 or display 798 or both. Storage device 794 and display 798 contain an embodiment of the present invention as exemplified in earlier described figures and text showing various circuit elements including getter material 104 as well as vacuum devices 140 having electron emitters that are focused. Preferably, the electron lens element exposed to the low pressure environment such as second lens element 630 shown in Fig. 6 includes getter material 104.

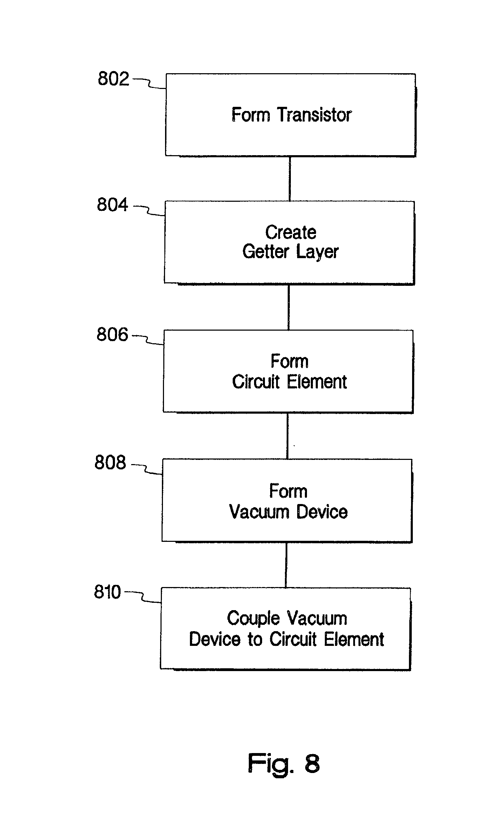

A method of manufacturing an electronic device is shown as a flow diagram in Fig. 8, the electronic device utilizes a getter material as method of maintaining a low pressure and as a portion of a circuit element. In step 802 transistors and other logic elements are formed for those applications requiring such elements. Preferably, the transistors and logic elements are formed in a silicon wafer having a thickness of about 300-700 microns. The logic elements and transistors are, preferably, formed using conventional semiconductor processing equipment. Although the substrate preferably is silicon, other materials may also be utilized, such as, for example, various glasses, aluminum oxide, polyimide, silicon carbide, and gallium arsenide. For example transistors and logic devices fabricated on glass substrates using polysilicon thin-film-transistor (TFT) technology can be utilized.

In step 804 the getter layer is created on the substrate. The getter material is preferably applied using conventional sputtering, evaporation, or other vapor deposition techniques. However, other techniques such as electrophoresis, manual, or mechanical application, including screen printing, sprays or suspensions of the getter material in a suspending medium, can also be utilized. Getter materials include titanium, zirconium, thorium, hafnium, vanadium, yttrium, niobium, tantalum, and molybdenum. Preferably, the getter material is a zirconium-based alloy such as Zr-Al, Zr-V, Zr-V-Ti, or Zr-V-Fe alloys, and more preferably Zr-V-Ti or Zr-V-Fe alloys because of the lower activation temperatures used for these materials. In general, the getter material is formed as a uniform layer having a thickness between about 0.1 to about 10 microns, preferably between about 0.5microns to about 5.0 microns, and more preferably between about 0.75 microns to about 1.25 microns. Patterning of the getter layer is accomplished through any of the photolithographic and etching technologies well known in the art.

In step 806 the circuit elements are formed on the substrate. As described above a wide variety of circuit elements and combinations of elements can be utilized in the present invention. Preferably, conventional semiconductor processing equipment can be utilized. For example, a resistor, a conductor trace, an electron shield, or a metal contact to a doped region may be formed by blanket deposition of the getter material on the substrate with subsequent patterning and etching of the getter layer.

In step 808 the vacuum device is formed on the substrate. Preferably, the vacuum device is formed by utilizing conventional semiconductor fab processes and equipment. Typically the vacuum device is formed as a thick-film stack that utilizes etch selectivity between different layers, as well as etch stop capability and designs and deposition conditions that form low stress forces between the layers as is well known in the art. For example, an electron emitter vacuum device includes an electron supply layer that is preferably a heavily doped semiconductor substrate such as silicon where the doping is preferably n-type doping such as phosphorous, arsenic, or antimony. A tunneling layer is then created on the surface of the electron supply layer and is preferably a thin oxide layer about 200 Angstroms thick. A cathode or electron emitter layer is then applied over the surface of the tunneling layer. The electron emitter layer is preferably formed from a deposition of platinum or optionally gold about 100 Angstroms thick.

In step 810 conductive traces are formed that couple the vacuum device to various circuit elements such as transistors, capacitors, electron lens structures to name a few. Preferably the conductive traces are formed using the getter material as described above. However, depending on the particular application, the conductive traces or some portion thereof may include other conductive materials. For example, metals, conductive inks, or organic conductors such as thiophene compounds and other materials well known in the art may also be utilized.

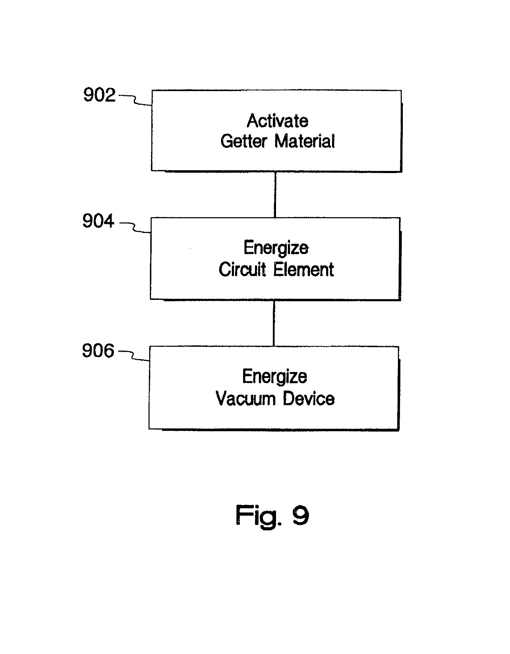

A method of using an electronic device utilizing a getter material as a method of maintaining a low pressure and as a portion of a circuit element is shown as a flow diagram in Fig. 9. In step 902 the getter material is activated to maintain a vacuum or reduced pressure. Preferably, the getter material is activated by placing the electronic device in an oven and heating the device and getter material to a sufficient temperature for a prescribed time. However, radio frequency power (RF) or laser power also may be utilized to activate the getter material, as well as heat generated by operation of the electronic device may also be used to activate the getter material. The time of heating depends on the particular getter material used and the temperature to which it is heated. The higher the temperature typically the shorter the time required to activate the getter material.

In step 904 a circuit element is energized by applying an appropriate signal through a portion of the getter material that forms at least an electrical portion of the circuit element. In step 906 a vacuum device is energized by applying an appropriate signal through preferably a portion of the getter material that forms at least a portion of an electrical interconnection between a circuit element and the vacuum device.

While the present invention has been particularly shown and described with reference to the foregoing preferred and alternative embodiments, those skilled in the art will understand that many variations may be made therein without departing from the spirit and scope of the invention as defined in the following claims. This description of the invention should be understood to include all novel and non-obvious combinations of elements described herein, and claims may be presented in this or a later application to any novel and non-obvious combination of these elements. The foregoing embodiments are illustrative, and no single feature or element is essential to all possible combinations that may be claimed in this or a later application.

## Claims

1. An electronic device (100, 700) comprising:
a non-evaporable getter material (104) having a surface exposed to a low pressure environment;
at least one circuit element (102, 550, 560, 570), wherein said non-evaporable getter material forms at least a portion of said at least one circuit element; and
at least one vacuum device (140, 240, 340, 440, 640) electrically coupled to said at least one circuit element.

2. The electronic device of claim 1, further comprising:
a substrate (110, 210, 310, 410, 510, 610), wherein said at least one circuit element and said at least one vacuum device are disposed over said substrate;
a cover (490);
a vacuum seal (480) attached to said substrate and to said cover wherein said vacuum seal, said substrate, and said cover define an interspace region (494) and provide a package enclosing said non-evaporable getter material and said vacuum device; and
at least one transistor (412) formed on said substrate and electrically coupled to said at least one vacuum device, wherein said at least one vacuum device further comprises:
an electron emitter device (640); and
a lens element (230, 330, 332, 630, 632, 634) that creates a focused beam of electrons emitted from said electron emitter device.

3. A display device (798) comprising:
at least one electronic device of claim 2; and
an inert gas, wherein said interspace region includes said inert gas.

4. The display device of claim 3, wherein said inert gas is selected from the group consisting of nitrogen, helium, neon, argon, krypton, xenon, and combinations thereof.

5. The electronic device of claim 1, wherein said non-evaporable getter material comprises a metal selected from the group consisting of molybdenum, titanium, thorium, hafnium, zirconium, vanadium, yttrium, niobium, tantalum and mixtures thereof.

6. The electronic device of claim 1, wherein said non-evaporable getter material is comprised of a metal, selected from the group consisting of Zr-Al alloys, Zr-V alloys, Zr-V-Ti alloys, Zr-V-Fe alloys, and mixtures thereof.

7. The electronic device of claim 1, wherein said non-evaporable getter material further comprises a layer having a thickness in the range from about 0.1 micron to about 10.0 micron.

8. The electronic device of claim 1, wherein said at least one circuit element further comprises a metal layer, and said at least one circuit element is selected from the group consisting of a conductor trace (570), an electron lens, an electric field shield, a resistor (560), a capacitor, an inductor (550), a Schottky contact, a gate metal contact, and combinations thereof, wherein said non-evaporable getter material substantially forms a surface of said at least one circuit element exposed to a low pressure environment, and said metal layer substantially minimizes the electrical conductivity and residual stress of said at least one circuit element.

9. A method of manufacturing an electronic device comprising the steps of:
forming (806) at least one circuit element;
creating (804) a non-evaporable getter material disposed over a substrate, wherein said non-evaporable getter material forms at least a portion of said at least one circuit element;
forming (808) a least one vacuum device on a substrate; and
coupling (810) said at least one vacuum device electrically to said at least one circuit element.

10. The method of claim 9, further comprising the step of forming (802) at least one transistor electrically coupled to said at least one vacuum device.

11. The method of claim 9, wherein said creating step further comprises the step of creating a non-evaporable getter material selected from the group consisting of molybdenum, titanium, thorium, hafnium, zirconium, vanadium, yttrium, niobium, tantalum and mixtures thereof.

12. The method of claim 9, wherein said creating step further comprises the step of creating a non-evaporable getter material selected from the group consisting of Zr-Al alloys, Zr-V alloys, Zr-V-Ti alloys, Zr-V-Fe alloys, and mixtures thereof.

13. The method of claim 9, wherein said creating step further comprises the step of creating a non-evaporable getter material as a layer having a thickness from about 0.1 micron to about 10.0 micron.

14. The method of claim 9, wherein said step of forming at least one circuit element, further comprises the step of forming at least one circuit element selected from the group consisting of a conductor trace (570), an electron lens, an electric field shield, a resistor (560), a capacitor, an inductor (550), a Schottky contact, a gate metal contact, and combinations thereof.

15. An electronic device produced by the method of claim 9, 10, 11, 12, 13 or 14.

16. A method of using an electronic device comprising the steps of:
activating (902) a non evaporable getter material to maintain a reduced pressure;
energizing (904) at least one circuit element wherein said non-evaporable getter material forms at least a portion of said at least one circuit element; and
energizing (906) at least one vacuum device electrically coupled to said at least one circuit element.

17. The method of claim 16, wherein said step of energizing at least one circuit element, further comprises the step of energizing at least one circuit element selected from the group consisting of a conductor trace (570), an electron lens, an electric field shield, a resistor (560), a capacitor, an inductor (550), a Schottky contact, a gate metal contact, and combinations thereof.

18. An electronic device comprising:
means for activating a non-evaporable getter material to maintain a reduced pressure;
means for energizing at least one circuit element via said non-evaporable getter material; and
means for energizing at least one vacuum device electrically coupled to said at least one circuit element.
